# EUROPEAN PATENT SPECIFICATION

(11) **EP 0 978 726 B1**
(45) Date of publication and mention of the grant of the patent: **28.09.2005**
(21) Application number: 99114692.9
(22) Date of filing: 27.07.1999
(51) Int. Cl.: G01R 31/317

(54) **Semiconductor device having a test circuit**
Halbleitereinrichtung mit einer Prüfschaltung
Dispositif sèmi-conducteur avec un circuit d'essay

(30) Priority: 30.07.1998 JP 21567798
(43) Date of publication of application: 09.02.2000
(73) Proprietor: Oki Electric Industry Co., Ltd., Tokyo (JP)
(72) Inventor: Shona, Yoshihiro, c/o Oki Electric Industry Co., Tokyo (JP)
(74) Representative: Betten & Resch

(56) References cited:
- EP-A- 0 283 186
- EP-A- 0 780 851
- US-A- 4 158 147
- US-A- 4 716 302
- US-A- 4 918 385
- US-A- 5 384 741
- PATENT ABSTRACTS OF JAPAN vol. 017, no. 375 (E-1397), 14 July 1993 (1993-07-14) & JP 05 063090 A (SEIKO INSTR INC), 12 March 1993 (1993-03-12)

## Description

### BACKGROUND OF THE INVENTION

### FIELD OF THE INVENTION

The present invention generally relates to a semiconductor device having a test circuit, more particularly, to a semiconductor device having a test circuit which enables a test operation before shipment to a user and which disables the test function after the test operation.

### DESCRIPTION OF THE RELATED ART

A shipment test checks whether a produced semiconductor device operates correctly, and is executed before the device is shipped to the user. Hence, the semiconductor device includes a test circuit for the shipment test in addition to a circuit for executing an original function, for example memory function.

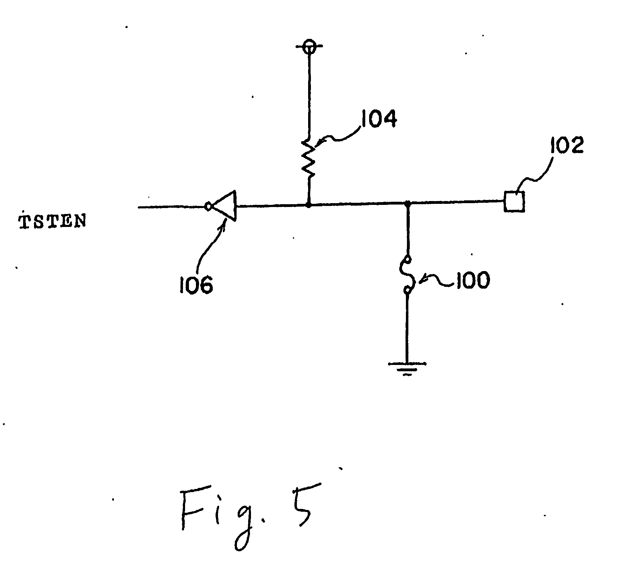

Fig. 5 is a circuit diagram showing a conventional test circuit.

The conventional test circuit is made up of a metal fuse 100, a test fuse terminal 102 (a test fuse pad), a pull up resistor 104, and an inverter gate 106.

The metal fuse 100 is made of a fine metal wiring and has one end connected to a ground and the other end connected to the test fuse terminal 102, one end of the pull up resistor 104 and an input terminal of the inverter gate 106.

The inverter gate 106 can output a signal having an H level or an L level. These output signals are used as an enable signal (hereinafter a test enable signal) which cause a test function (a shipment test) to be enabled or make a test command valid.

In the case where the shipment test is executed, the test terminal 102 is used in an open state. When a supply voltage is supplied to the semiconductor device while the test terminal 102 is in the open state, a through current flows from a voltage source to the ground through the pull up resistor 104 and the metal fuse 100. At this time, since there is no voltage difference between one end of the metal fuse 100 and the other end of the metal fuse 100, the input terminal of the inverter gate 106 becomes the L level and hence the inverter gate 106 outputs a test enable signal TSTEN having the H level. When the inverter gate 106 outputs the test enable signal TSTEN having the H level, the test command becomes valid and the test function is enabled. As a result the shipment test can be executed.

When a predetermined voltage level is applied to the test fuse terminal 102 after the shipment test has been done, a current flows from the test terminal 102 to the ground through the metal fuse 100. At this time, since the current passing through the metal fuse 100 has a value which exceeds a predetermined breakdown value, the metal fuse 100 is cut or broken by this current.

Then the semiconductor device, which has been already tested, is shipped to a user in the state that the metal fuse 100 is cut.

In such a semiconductor device having the metal fuse 100 which has been cut, there is the case where the supply voltage is applied to the semiconductor device again while the test terminal 102 is kept open. In this case, since the metal fuse 100 has been already cut, the current can not flow from the voltage source to the ground through the metal fuse 100. Therefore, the input terminal of the inverter gate 106 goes to the H level and thus the inverter gate 106 outputs the test enable signal TSTEN having the L level.

When the test enable signal TSTEN is in the L level, the test command is invalid and the test function is disabled. As a result, the shipment test can not been executed again after the shipment test has been done. That is, the test function in the semiconductor device is disabled by cutting the metal fuse 100 after the shipment test has been done.

However, in such a semiconductor device which has the cut metal fuse 100 and which is shipped to the user; there is the case where the user grounds the test terminal 102 and applies the supply voltage to the semiconductor device. In this case, even though the metal fuse 100 has been already cut, the current flows from the voltage source to the grounded test terminal 102 through the pull up resistor 104. Therefore, the input terminal of the inverter gate 106 goes to the L level and thus the inverter gate 106 outputs the test enable signal TSTEN having the H level. In this case, although the test function has been disabled once after the shipment test has been done, the test function may be revived and is executed again.

In some cases, the semiconductor device is used for an IC card or the like that requires a higher security. If the semiconductor device is such as that described above, there has been a problem in that it is difficult to ensure higher security since the test function can be revived and executed again.

Japanese laid open patent No. 5-160345 describes a test function that can not be enabled after the shipment test has been done. In this reference, however a higher voltage than the voltage source is needed to cut the fuse element. Therefore, there is a possibility that an element other than the fuse element formed in the semiconductor device will be broken.

Consequently, there has been a need for an improved semiconductor device.

In patent abstracts of Japan 0506090, a regulating method for a fuse trimming circuit is disclosed. To prevent deviation from desired characteristics at the time of fuse trimming by temporarily trimming according to data read in an IC, a combination of fuse melts for obtaining desired characteristics is determined and then a fuse is cut. The trimming fuse is connected to a trimming pad and an output signal is selected by a trimming block signal and sent to an block to be trimmed. When temporary trimming is conducted, characteristics after a fuse melt is not deviated from a desired standard.

In U.S. patent 5,384,741, a semiconductor memory device having a circuit for preventing the operation of a test mode is disclosed. The device includes a first terminal for receiving an externally applied high voltage exceeding a power supply potential, a second terminal for receiving an externally applied test mode signal and a high voltage detector for detecting that a high voltage signal has been applied through the first terminal. A test mode signal holding circuit is responsive to the high voltage detector and hold the test mode signal applied through the second terminal. A test circuit is responsive to the test mode signal held in the test mode signal holding circuit and performs a test in the semiconductor memory device. A disabling circuit is provided to disable the high voltage detector.

In EP-A-0780851, a resistor structure is disclosed. The resistance value of the resistor structure can be electrically adjusted after fabrication by the tester during a test operation so that its equivalent resistance closely approximates the desired nominal value.

### SUMMARY OF THE INVENTION

It is an object of the present invention is to provide a semiconductor device that may inhibit a test function after a shipment test.

It is another object of the present invention is to provide a semiconductor device that does not need a special voltage for a shipment test.

It is another object of the present invention is to provide a semiconductor device that may obtain higher security.

In accordance with the present invention, there are provided semiconductor devices as defined in independent claims 1 and 5.

According to an aspect of the present invention; for achieving the above object, there is provided a semiconductor device including a first voltage node which is supplied with a first voltage level, a second voltage node which is supplied with a second voltage level that is higher than the first voltage level, a test terminal, and an internal node. The semiconductor device further includes a fuse element coupled between the first voltage node and the internal node, a resistive element which is coupled between the second voltage node and the internal node, and a current limit element which is coupled between the internal node and the test terminal and which allows current flow from the test terminal to the internal node and which restricts current flow from the internal node to the test terminal. The semiconductor device also includes a test execution circuit which is coupled to the internal node and executes a test function of the semiconductor device according to the voltage level of the internal node.

The above and further objects and novel features of the invention will more fully appear from the following detailed description, appended claims and the accompanying drawings.

### BRIEF DESCRIPTION OF THE DRAWINGS

Fig. 1 is a circuit diagram showing a test circuit according to a first embodiment.
Fig. 2 is a circuit diagram showing a test circuit according to a second embodiment.
Fig. 3 is a circuit diagram showing a test circuit according to a third, preferred embodiment of the present invention.
Fig. 4 is a circuit diagram showing a test circuit according to a fourth, preferred embodiment of the present invention.
Fig. 5 is a circuit diagram showing a conventional test circuit.

### DETAILED DESCRIPTION OF THE PREFERRED EMBODIMENTS

### First embodiment

A semiconductor device according to the present invention will be explained hereinafter with reference to the figures. In order to simplify explanations, like elements are given like or corresponding reference numbers through this specification and figures.

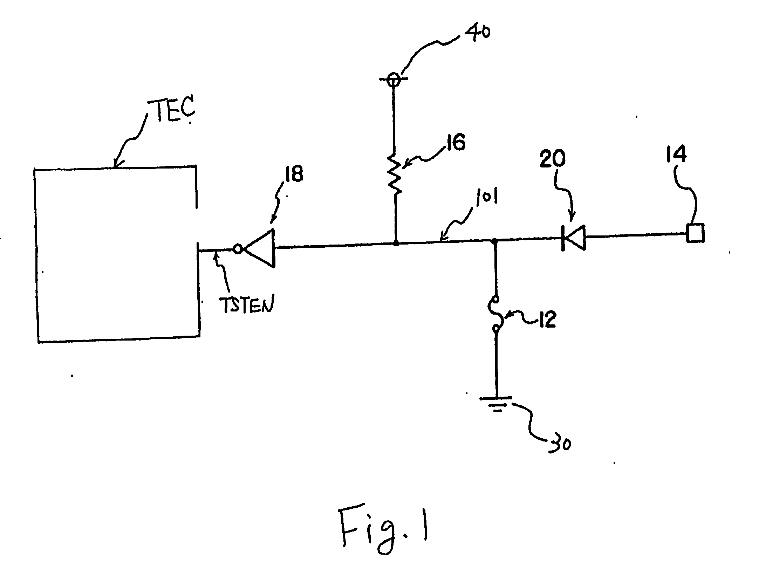

Fig. 1 is a circuit diagram showing a test circuit according to a first embodiment which is not claimed by but useful for understanding the present invention.

The test circuit is built in the semiconductor device. The test circuit is made up of a metal fuse 12, a test fuse terminal 14 (a test fuse pad), a pull up resistor 16, an inverter gate 18, and a diode 20.

The diode 20 has an anode connected to the test terminal 14 and a cathode connected to a node 101. The metal fuse 12 is connected between the node 101 and a ground 30 (for example, 0v). The pull up resistor 16 is connected between a voltage source 40 (for example, 5v) and the node 101. A resistance value of the resistor 16 is set at a predetermined value so that a current which passes through the metal fuse 12 can not cut the metal fuse 12 when only the supply voltage (voltage source 40) is applied to the test circuit of the semiconductor device.

The inverter gate 18 has an input terminal connected to the node 101 and an output terminal connected to a test execution circuit TEC for executing a test function. A signal output from the inverter gate 18 is a test enable signal TSTEN which makes the test command valid or causes the test function to be enabled. A shipment test or the like are executed according to the voltage level of this test enable signal TSTEN. This shipment test checks whether the device that has been produced operates correctly. Furthermore, the shipment test is executed before the device is shipped to a user.

In this first embodiment, when the test enable signal TSTEN is in an H level, the test command becomes valid and the test function is enabled and thus the shipment test is executed. That is, as mentioned above, the output terminal of the inverter gate 18 is connected to the test execution circuit TEC in response to the test enable signal TSTEN having the H level. On the other hand, when the test enable signal TSTEN is in the L level, the test command becomes invalid and the test function is disabled and thus the shipment test is not executed.

Next, an operation of the first embodiment will be explained hereinafter

In the case where the shipment test is executed, the test fuse terminal 14 is in an open or floating state. When the supply voltage is supplied to the semiconductor device while the test fuse terminal 14 is in the open state, a through current flows from the voltage source 40 to the ground 30 through the pull up resistor 16 and the metal fuse 12. At this time, since the metal fuse 12 is not cut there is no voltage difference between the node 101 and the ground 30. Accordingly, the voltage level of the node 101 becomes the L level and thus the inverter gate 18 outputs the test enable signal TSTEN having the H level.

When the inverter gate 18 outputs the test enable signal TSTEN having the H level, the test command becomes valid and the test function is enabled. As a result, the shipment test can be executed by the test execution circuit TEC.

After the shipment test has been done, a predetermined voltage level, for example the supply voltage level, is applied to the test fuse terminal 14. When the predetermined voltage level is applied to the test fuse terminal 14, a current flows from the test terminal 14 to the ground 30 through the diode 20 and the metal fuse 12. This current is sufficiently high to cut the metal fuse 12, and the metal fuse 12 is cut by this current. After the metal fuse 12 has been cut, the test fuse terminal 14 is set at the open state again.

After that, the semiconductor device is shipped to a user in this state.

When the supply voltage is applied to the semiconductor device again by the user to operate the semiconductor device, current can not flow from the voltage source 40 to the ground 30 through the metal fuse 12, because the metal fuse 12 has been already cut Accordingly, the node 101 goes to the H level due to the action of the pull up resistor 16.

On the other hand, if the user tries to apply a voltage level, for example the ground voltage level, to the test fuse terminal 14, the node 101 can not go to the L level due to the action of the diode 20. That is, the diode 20 prevents current flows from the node 101 to the test fuse terminal 14. Therefore, the voltage level of the node 101 is maintained at the H level and thus the test enable signal TSTEN is maintained at the L level after the shipment test has been done.

Since the voltage level of the test enable signal TSTEN is kept at the L level at all times, the test command can not become valid and the test function can not be enabled later That is, the shipment test can not be revived by the user.

In the present embodiment, as mentioned above, the voltage level of the node 101 is kept at the H level (the voltage level of the test enable signal TSTEN is kept at the L level) after the metal fuse 12 is cut. Consequently even if the test fuse terminal 14 is grounded or any other voltage level is applied thereto after the shipment test has been done, the test command and the test function can not be revived.

Furthermore, such a semiconductor device can be used for an IC card or the like which requires a higher security, since the test command and the test function can not be revived by the user after shipment test.

Furthermore, since the test command or the test function can not be revived after the shipment test has been done, a circuit which has higher performance test functions and which executes many test commands may be built in the semiconductor device. Accordingly, it is possible to reduce the time for the shipment test. This makes it possible to improve the quality of the semiconductor device.

Furthermore, the metal fuse 12 can be cut by applying the supply voltage level to the test fuse terminal 14. Therefore, since a voltage level which is higher than the supply voltage level is not needed to cut the metal fuse 12, it is possible to prevent other elements formed in the semiconductor device from being broken inadvertently.

### Second embodiment

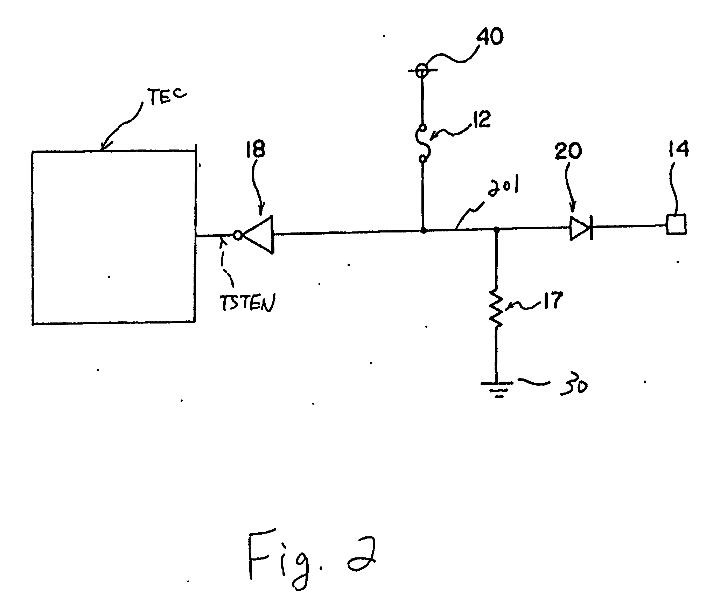

A semiconductor device according to a second embodiment which is not claimed by but useful for understanding the present invention will be explained hereinafter with reference to Fig. 2.

Fig. 2 is a circuit diagram showing a test circuit according to a second embodiment.

The test circuit is made up of a metal fuse 12, a test fuse terminal 14 (a test fuse pad), a pull down resistor 17, an inverter gate 18, and a diode 20.

The diode 20 has an anode connected to a node 201 and a cathode connected to the test terminal 14. The metal fuse 12 is connected between the node 201 and a voltage source 40. The pull down resistor 17 is connected between a ground 30 and the node 201. A resistance value of the resistor 17 is set at a predetermined value so that a current which passes through the metal fuse 12 can not cut the metal fuse 12 when only the supply voltage (voltage source 40) is applied to the semiconductor device.

The inverter gate 18 has an input terminal connected to the node 201 and an output terminal connected to a test execution circuit TEC for executing a test function. A signal output from the inverter gate 18 is the test enable signal TSTEN which makes the test command valid and causes the test function to enable. A shipment test or the like is executed according to the voltage level of this test enable signal TSTEN.

In this second embodiment, when the test enable signal TSTEN is in the L level, the test command becomes valid and the test function is enabled and thus the shipment test is executed. On the other hand, when the test enable signal TSTEN is in the H level, the test command becomes invalid and the test function is disabled and thus the shipment test is not executed.

Next, an operation of the second preferred embodiment will be explained hereinafter.

In the case where the shipment test is executed, the test fuse terminal 14 is in an open or floating state. When the supply voltage is supplied to the semiconductor device while the test fuse terminal 14 is in the open state, a through current flows from the voltage source 40 to the ground 30 through the pull down resistor 17 and the metal fuse 12. At this time, since the metal fuse 12 is not cut, there is no voltage difference between the node 201 and the voltage source 40. Accordingly, the voltage level of the node 201 become the H level and thus the inverter gate 18 outputs the test enable signal TSTEN having the L level.

When the inverter gate 18 outputs the test enable signal TSTEN having the L level, the test command becomes valid and the test function is enabled. As a result, the shipment test can be executed by the test execution circuit TEC.

After the shipment test has been done, a predetermined voltage level. for example the ground voltage level, is applied to the test fuse terminal 14. When the predetermined voltage level is applied to the test fuse terminal 14, a current flows from the voltage source 40 to the test terminal 14 through the metal fuse 12 and the diode 20. At this time, this current is sufficiently high to cut the metal fuse 12, and the metal fuse 12 is cut by this current. After the metal fuse 12 has been cut, the test fuse terminal 14 is set at the open state again. The semiconductor devices then are shipped to a user in this state.

When the supply voltage is applied to the semiconductor device again by the user to operate the semiconductor device, current can not flow from the voltage source 40 to the ground 30, because the metal fuse 12 has been cut. Accordingly, the node 201 goes to the L level due to the action of the pull down resistor 17.

On the other hand, if the user tries to apply a voltage level, for example the supply voltage level, to the test fuse terminal 14, the node 201 can not go to the H level due to the action of the diode 20. That is, the diode 20 prevents current flows from the test fuse terminal 14 to the node 201.

Therefore, the voltage level of the node 201 is maintained at the L level and thus the test enable signal TSTEN is maintained at the H level after the shipment test has been done.

Since the voltage level of the test enable signal TSTEN is kept at the H level at all times, the test command can not become valid and the test function can not be enabled later. This means that the shipment test can not be revived by the user.

In the present embodiment, the voltage the voltage level of the node 201 is kept at the L level (the voltage level of the test enable signal TSTEN is kept at the H level) after the metal fuse 12 is cut. Consequently, even if a voltage level is applied to the test fuse terminal 14 after the shipment test has been done, the test command and the test function can not be revived.

### Third embodiment

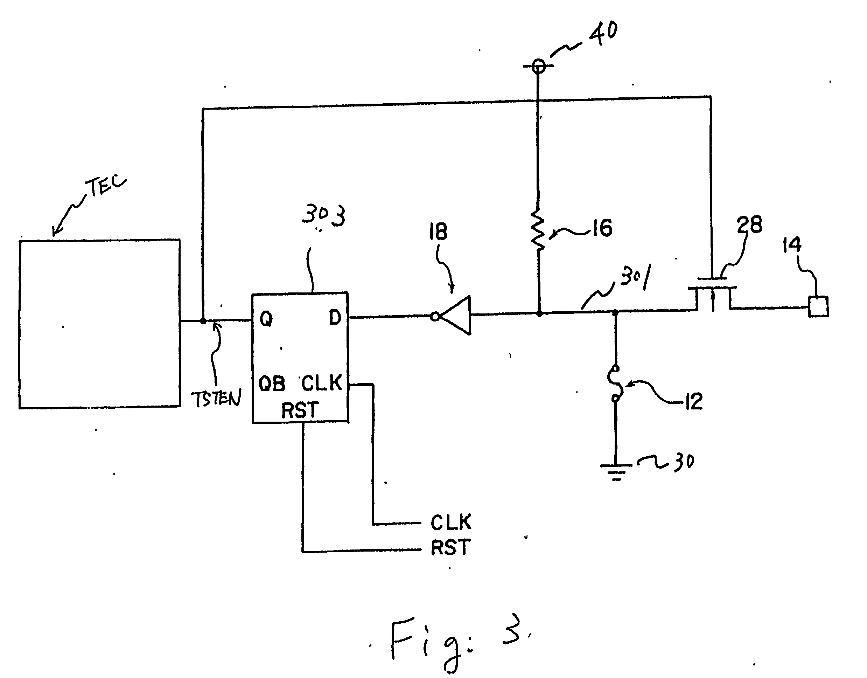

A semiconductor device according to a third preferred embodiment of the present invention will be explained hereinafter with reference to Fig. 3.

Fig. 3 is a circuit diagram showing a test circuit according to a third preferred embodiment of the present invention.

In the first and the second embodiments, the current which flows from the node 101 to the test fuse terminal 14 or the current which flows from the test fuse terminal 14 to the node 201 is limited by the characteristics of the diode 20, whereby the shipment test is not revived.

On the other hand, in the third embodiment, the diode 20 in Fig. 1 or Fig. 2 is replaced with an N-channel MOS transistor 28 (hereinafter NMOS) and a D-type flip flop 303 (hereinafter D-F/F) is provided at an output terminal of an inverter gate 18. This structure is particularly effective in the case where a specific wafer process being used can not produce a diode.

In Fig. 3, the test circuit is made up of a metal fuse 12, a test fuse terminal 14 (a test fuse pad), a pull up resistor 16, the inverter gate 18, the NMOS 28, and the D-F/F 303.

The NMOS 28 has one electrode (source or drain) connected to the test fuse terminal 14, the other electrode (drain or source) connected to an node 301, and a gate electrode connected to an output terminal Q of the D-F/F 303. The metal fuse 12 is connected between the node 301 and a ground 30. The pull up resistor 16 is connected between a voltage source 40 and the node 301. A resistance value of the resistor 16 is set at a predetermined value so that a current which passes through the metal fuse 12 can not cut the metal fuse 12 when only the supply voltage (voltage source 40) is applied to the semiconductor device. The inverter gate 18 has an input terminal connected to the node 301 and an output terminal connected to an input terminal of the D-F/F 303.

The D-F/F 303 functions as a latch circuit for latching a signal output from the inverter gate 18. The input terminal D of the D-F/F 303 is connected to the output terminal of the inverter gate 18. The output terminal of the D-F/F 303 is connected to the gate electrode of the NMOS 28. An output signal of the D-F/F 303 is utilized as a test enable signal TSTEN and a control signal for controlling ON/OFF states of the NMOS 28. That is, when the test enable signal TSTEN is in the H level, the NMOS 28 turns ON and when the test enable signal TSTEN is in the L level, the NMOS 28 turns OFF.

The D-F/F 303 also has a clock input terminal CLK for inputting a clock signal which is used to control an overall operation of the semiconductor device itself. The clock signal applied to the clock input terminal CLK may be a signal generated at an external device or may be a signal generated within the semiconductor device.

The D-F/F 303 further has a reset terminal RST for inputting a power on reset signal RST or the like. The power on reset signal RST is applied to the reset terminal RST at the time of starting the operation of the semiconductor device. When D-F/F 303 receives the power on reset signal RST, the signal received at the input terminal D is reset. That is, the test enable signal TSTEN output from the D-F/F 303 goes to the L level regardless of the voltage level of the signal received at the input terminal D.

Next, an operation of the third preferred embodiment will be explained hereinafter.

In the case where the shipment test is executed, the test fuse terminal 14 is in an open or floating state. When the supply voltage is supplied to the semiconductor device while the test terminal 14 is in the open state, a through current flows from the voltage source 40 to the ground 30 through the pull up resistor 16 and the metal fuse 12.

At this time, there is no voltage difference between the node 301 and the ground 30, the voltage level of the node 301 goes to the L level and thus the inverter gate 18 outputs the H level. The D-F/F 303 receives this H level synchronized with the clock signal and outputs the test enable signal TSTEN having the H level. Therefore, the test command becomes valid and the test function is enabled, and thus the shipment test can be executed by the test execution circuit TEC.

Furthermore, since the gate electrode of the NMOS 28 receives the H level at this time, the NMOS 28 turns ON. The NMOS 28 maintaines the ON state while the metal fuse 12 is not cut.

After the shipment test has been done, supply of the clock signal CLK is stopped and a predetermined voltage level, for example the supply voltage level, is applied to the test fuse terminal 14. At this time, since the NMOS 28 is in the ON state, when the predetermined voltage level is applied to the test fuse terminal 14, a current flows from the test fuse terminal 14 to the ground 30 through the NMOS 28 and the metal fuse 12. This current is sufficiently high to cut the metal fuse 12 and the metal fuse 12 is cut by this current. The semiconductor device is then shipped to a user in this state.

At the user, the supply voltage is applied to the semiconductor device again to operate the semiconductor device. The power on reset signal is also applied to the reset terminal RST of the D-F/F 303. Accordingly, the D-F/F 303 outputs the test enable signal TSTEN having the L level. Also the output signal of the inverter gate 18 is in the L level. Therefore, even if the semiconductor device starts operation and then the clock signal is applied to the clock terminal CLK, the test enable signal TSTEN is maintained at the L level. As a result, the test command becomes invalid and the test function is disabled, and thus the shipment test can not be executed.

Furthermore, the NMOS 28 is kept in the OFF state while the test enable signal TSTEN is in the L level. Consequently even if the user tries to revive the test operation and applies a voltage level, for example the ground voltage level, to the test fuse terminal 14, the node 301 can not go to the L level due to the action of the NMOS 28. That is, the NMOS 28 prevents current flow from the test fuse terminal 14 to the node 301.

Accordingly the voltage level of the node 301 is maintained at the H level and thus that of the test enable signal TSTEN is maintained at the L level after the shipment test has been done.

Since the voltage level of the test enable signal TSTEN is kept at the L level at all times, the test command can not become valid and the test function can not be enabled later. This means that the shipment test can not be revived by the user.

Since the third preferred embodiment can limit the current flowing from the test fuse terminal 14 by providing the D-F/F 303 which latches the output signal of the inverter gate 18 and controls the ON/OFF states of the NMOS 28, the test command and the test function can not be revived after the shipment test has been done.

### Fourth embodiment

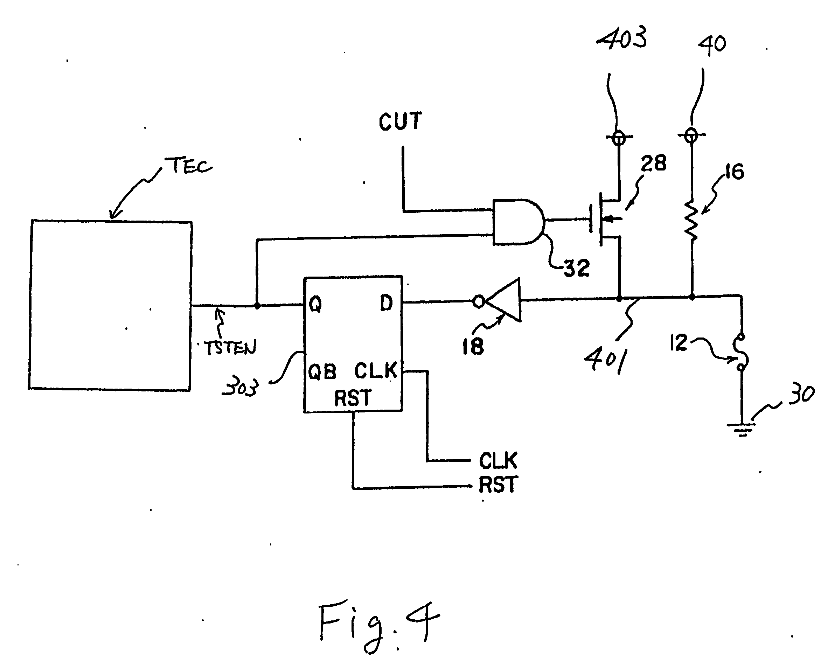

A semiconductor device according to a fourth preferred embodiment of the present invention will be explained hereinafter with reference to Fig. 4.

Fig. 4 is a circuit diagram showing a test circuit according to a fourth preferred embodiment of the present invention.

The test circuit is made up of a metal fuse 12, a pull up resistor 16, an inverter gate 18, a D-F/F 303, an NMOS 28, and an AND gate 32.

The metal fuse 12 is connected between an node 401 and a ground 30 (for example, 0v). The pull up resistor 16 is connected between a voltage source 40 (for example. 5v) and the node 401. A resistance value of the resistor 16 is set at a predetermined value so that a current which passes through the metal fuse 12 can not cut the metal fuse 12 when only the supply voltage (voltage source 40) is applied to the semiconductor device. The NMOS 28 has one electrode (source or drain) connected to a voltage source 403 (for example, 5v), the other electrode (drain or source) connected to the node 401, and a gate electrode connected to an output terminal of the AND gate 32. The voltage source 403 corresponds to the test fuse terminal 14 of the first and the second preferred embodiments. However, the voltage source 403 may be replaced with the voltage source 40.

The inverter gate 18 has an input terminal connected to the node 401 and an output terminal connected to an input terminal D of the D-F/F 303.

The D-F/F 303 functions as a latch circuit for latching a signal output from the inverter gate 18. The operation of the D-F/F 303 is the same as that of the third preferred embodiment.

The AND gate 32 has a first input terminal for inputting a cut signal CUT and a second input terminal connected to an output terminal Q of the D-F/F 303. The cut signal CUT serves as a control signal for cutting the metal fuse 12 and is generated from a circuit which is located outside of the test circuit. The cut signal CUT usually is in the L level, but goes to the H level when cutting of the metal fuse 12 is required.

The AND gate 32 outputs a signal having the H level only when both the cut signal CUT and the test enable signal TSTEN are the H level. Hence, the NMOS 28 turns ON at only this time.

Next, an operation of the fourth preferred embodiment will be explained hereinafter.

In the case where the shipment test is executed, the supply voltage is supplied to the semiconductor device. Since the cut signal CUT is in the L level at this time, the AND gate 32 outputs the L level. Therefore, the NMOS 28 is in the OFF state.

A through current flows from the voltage source 40 to the ground 30 through the pull up resistor 16 and the metal fuse 12.

At this time, there is no voltage difference between the node 401 and the ground 30, the voltage level of the node 401 goes to the L level, and thus the inverter gate 18 outputs the H level.

The D-F/F 303 receives this H level synchronized with the clock signal and outputs the test enable signal TSTEN having the H level. Therefore, the test command becomes valid and the test function is enabled, and thus the shipment test can be executed by the test execution circuit TEC.

After the shipment test has been done, the cut signal CUT is set at the H level. At this time, since the test enable signal TSTEN is still at the H level, the AND gate 32 outputs the H level. Hence, the NMOS 28 turns ON and thus a current flows from the voltage source 403 to the ground 30 through the NMOS 28 and the metal fuse 12. This current is sufficiently high to cut the metal fuse 12, and the metal fuse 12 is cut by this current. Then, the cut signal CUT is set at the L level and thus the NMOS 28 turns OFF. The semiconductor device then is shipped to a user in this state.

At the user, the supply voltage is applied to the semiconductor device again by the user to operate the semiconductor device. The power on reset signal RST is also applied to the reset terminal RST of the D-F/F 303. Accordingly, the D-F/F 303 outputs the test enable signal TSTEN having the L level. Also, the output signal of the inverter gate18 is in the L level. Therefore, even if the semiconductor device starts its operation and then the clock signal is applied to the clock terminal CLK, the test enable signal TSTEN is maintained at the L level at all times. As a result, the test command becomes invalid and the test function is disabled, and thus the shipment test can not be executed.

As mentioned above, since the voltage level of the test enable signal TSTEN is kept at the L level after the metal fuse 12 has been cut once, the test command can not become valid and the test function can not be enabled later. This means that the shipment test can not be revived by the user.

Furthermore, the cut signal CUT is one of the test functions and is generated by a command (fuse cutting order) from an external circuit formed in the semiconductor device. Consequently, this cut signal CUT can not be easily produced by the user. That is, the users may not recognize the existence of this cut signal CUT. This means that the semiconductor device can have higher security.

Furthermore, in the fourth preferred embodiment, the test fuse terminal is not needed. Accordingly, an area in which circuit elements are formed may be reduced.

In the third and the fourth preferred embodiments, teat circuits which include the NMOS 28 are described. However, the invention is not limited to the NMOS. For example, a P channel MOS transistor (PMOS) or a bipolar transistor may be used instead of the NMOS, in which case the polarity of the signals inputted their control terminals, i.e. a gate electrode or a base electrode, must be considered. For example, in Fig. 3, in the case where the NMOS 28 is replaced with the PMOS, another inverter gate must be provided between the output terminal Q of the D-F/F 303 and the gate of the PMOS.

While the preferred form of the present invention has been described, it is to be understood that modifications will be apparent to those skilled in the art without departing from the scope of the invention which is to be determined solely by the following claims.

## Claims

1. A semiconductor device comprising:
a first voltage node (30) which is supplied with a first voltage level;
a second voltage node (40) which is supplied with a second voltage level;
a test terminal (14),
an internal node (301);
a fuse element (12) coupled between said first voltage node and said internal node;
a resistive element (16) coupled between said second voltage node and said internal node;
a test execution circuit TEC, coupled to a test enable signal output circuit, which executes a test function of said semiconductor device in response to a test enable signal;
**characterised by**
a switch, coupled between said internal node and said test terminal, which electrically connects said internal node to said test terminal when enabled by said test enable signal:
said test enable signal output circuit, coupled to said internal node, which outputs the test enable signal according to the voltage level of said internal node: and
wherein said test enable signal output circuit includes:
an inverter gate (18) having an input terminal coupled to said internal node and an output terminal;
a latch circuit (303), coupled between the output terminal of said inverter gate and said test execution circuit, which latches a signal output from said inverter gate and outputs the test enable signal.

2. A semiconductor device as set forth claim 1, wherein said switch comprises a MOS transistor (28) having one electrode coupled to said internal node, another electrode coupled to said test terminal and a gate electrode coupled to said test enable signal output circuit.

3. A semiconductor device as set forth in claim 1 or 2, wherein the second voltage level is higher than the first voltage level and wherein said fuse element is cut when the test enable signal is applied to said switch and a third voltage level that is higher than the first voltage level is applied to said test terminal.

4. A semiconductor device as set forth claim 3, wherein the third voltage level is substantially the same as the second voltage level.

5. A semiconductor device comprising:
a first voltage node (30) which is supplied with a first voltage level;
a second voltage node (40) which is supplied with a second voltage level;
an internal node (401);
a fuse element (12) coupled between said first voltage node and said internal node;
a resistive element (16), coupled between said second voltage node and said internal node, which maintains a voltage level of said internal node at the second voltage level:
a test execution circuit TEC, coupled to a test enable signal output circuit, which executes a test function of said semiconductor device in response to a test enable signal;
**characterised by**
a switch, coupled between said internal node and said second voltage node, which electrically connects said internal node to said second voltage node when enabled by a switch control signal;
said test enable signal output circuit, coupled to said internal node, which outputs said test enable signal according to the voltage level of said internal node;
a fuse cut signal input node for inputting a fuse cut signal CUT; and
a switch control circuit (32); coupled to said test enable signal output circuit and said fuse cut signal input node, which outputs the switch caontrol signal in response to the fuse cut signal and the test enable signal; and
wherein said test enable signal output circuit includes:
an inverter gate (18) having an input terminal coupled to said internal node and an output terminal;
a latch circuit (303), coupled between the output terminal of said inverter gate and said test execution circuit, which latches a signal output from said inverter gate and outputs the test enable signal.

6. A semiconductor device as set forth claim 5, wherein said switch comprises a MOS transistor (28) having one electrode coupled to said internal node, another electrode coupled to said second voltage node and a gate electrode coupled to said switch control circuit.

7. A semiconductor device as set forth in one of claims 1 to 6, wherein said resistive element comprises a resistor having one end coupled to said internal node and another end coupled to said second voltage node.

8. A semiconductor device as set forth in one of claims 5 to 7, wherein said fuse element is cut when the switch control signal is applied to said switch.

## Patentansprüche

1. Halbleitervorrichtung, die folgendes aufweist:
einen ersten Spannungsknoten (30), dem ein erster Spannungspegel zugeführt wird;
einen zweiten Spannungsknoten (40), dem ein zweiter Spannungspegel zugeführt wird;
einen Testanschluss (14);
einen internen Knoten (301);
ein Sicherungselement (12), das zwischen dem ersten Spannungsknoten und dem internen Knoten gekoppelt ist;
ein Widerstandselement (16), das zwischen dem zweiten Spannungsknoten und dem internen Knoten gekoppelt ist;
eine mit einer Testfreigabesignal-Ausgabeschaltung gekoppelte Testausführungsschaltung TEC, die in Reaktion auf ein Testfreigabesignal eine Testfunktion der Halbleitervorrichtung ausführt;
**gekennzeichnet durch**
einen zwischen dem internen Knoten und dem Testanschluss gekoppelten Schalter, der den internen Knoten mit dem Testanschluss elektrisch verbindet, wenn er **durch** das Testfreigabesignal freigegeben wird;
die mit dem internen Knoten gekoppelte Testfreigabesignal-Ausgabeschaltung, die das Testfreigabesignal gemäß dem Spannungspegel des internen Knotens ausgibt; und
wobei die Testfreigabesignal-Ausgabeschaltung folgendes enthält:
ein Invertergatter (18) mit einem mit dem internen Knoten gekoppelten Eingangsanschluss und einem Ausgangsanschluss;
eine zwischen dem Ausgangsanschluss des Invertergatters und der Testausführungsschaltung gekoppelte Latchschaltung (303), die ein vom Invertergatter ausgegebenes Signal zwischenspeichert und das Testfreigabesignal ausgibt.

2. Halbleitervorrichtung nach Anspruch 1, wobei der Schalter einen MOS-Transistor (28) mit einer mit dem internen Knoten gekoppelten Elektrode, einer weiteren mit dem Testanschluss gekoppelten Elektrode und einer mit der Testfreigabesignal-Ausgabeschaltung gekoppelten Gate-Elektrode aufweist.

3. Halbleitervorrichtung nach Anspruch 1 oder 2, wobei der zweite Spannungspegel höher als der erste Spannungspegel ist und wobei das Sicherungselement aufgetrennt wird, wenn das Testfreigabesignal an den Schalter angelegt wird und ein dritter Spannungspegel, der höher als der erste Spannungspegel ist, an den Testanschluss angelegt wird.

4. Halbleitervorrichtung nach Anspruch 3, wobei der dritte Spannungspegel im Wesentlichen derselbe wie der zweite Spannungspegel ist.

5. Halbleitervorrichtung, die folgendes aufweist:
einen ersten Spannungsknoten (30), dem ein erster Spannungspegel zugeführt wird;
einen zweiten Spannungsknoten (40), dem ein zweiter Spannungspegel zugeführt wird;
einen internen Knoten (401);
ein Sicherungselement (12), das zwischen dem ersten Spannungsknoten und dem internen Knoten gekoppelt ist;
ein zwischen dem zweiten Spannungsknoten und dem internen Knoten gekoppeltes Widerstandselement (16), das einen Spannungspegel des internen Knotens auf dem zweiten Spannungspegel hält;
eine mit einer Testfreigabesignal-Ausgabeschaltung gekoppelte Testausführungsschaltung TEC, die in Reaktion auf ein Testfreigabesignal eine Testfunktion der Halbleitervorrichtung ausführt;
**gekennzeichnet durch**
einen zwischen dem internen Knoten und dem zweiten Spannungsknoten gekoppelten Schalter, der den internen Knoten mit dem zweiten Spannungsknoten elektrisch verbindet, wenn er **durch** ein Schaltersteuersignal freigegeben wird;
die mit dem internen Knoten gekoppelte Testfreigabesignal-Ausgabeschaltung, die das Testfreigabesignal gemäß dem Spannungspegel des internen Knotens ausgibt;
einen Sicherungsauftrennsignal-Eingangsknoten zum Eingeben eines Sicherungsauftrennsignals CUT; und
eine mit der Testfreigabesignal-Ausgabeschaltung und dem Sicherungstrennsignal-Eingangsknoten gekoppelte Schaltersteuerschaltung (32), die das Schaltersteuersignal in Reaktion auf das Sicherungstrennsignal und das Testfreigabesignal ausgibt; und
wobei die Testfreigabesignal-Ausgabeschaltung folgendes enthält:
ein Invertergatter (18) mit einem mit dem internen Knoten gekoppelten Eingangsanschluss und einem Ausgangsanschluss;
eine zwischen dem Ausgangsanschluss des Invertergatters und der Testausführungsschaltung gekoppelte Latchschaltung (303), die ein vom Invertergatter ausgegebenes Signal zwischenspeichert und das Testfreigabesignal ausgibt.

6. Halbleitervorrichtung nach Anspruch 5, wobei der Schalter einen MOS-Transistor (28) mit einer mit dem internen Knoten gekoppelten Elektrode, einer weiteren mit dem zweiten Spannungsknoten gekoppelten Elektrode und einer mit der Schaltersteuerschaltung gekoppelten Gate-Elektrode aufweist.

7. Halbleitervorrichtung nach einem der Ansprüche 1 bis 6, wobei das Widerstandselement einen Widerstand mit einem mit dem internen Knoten gekoppelten Ende und einem weiteren mit dem zweiten Spannungsknoten gekoppelten Ende aufweist.

8. Halbleitervorrichtung nach einem der Ansprüche 5 bis 7, wobei das Sicherungselement aufgetrennt wird, wenn das Schaltersteuersignal an den Schalter angelegt wird.

## Revendications

1. Dispositif à semiconducteurs, comprenant :
un premier noeud de tension (30) auquel est délivré un premier niveau de tension ;
un deuxième noeud de tension (40) auquel est délivré un deuxième niveau de tension ;
une borne de test (14) ;
un noeud interne (301) ;
un élément de fusible (12) couplé entre ledit premier noeud de tension et ledit noeud interne ;
un élément résistif (16) couplé entre ledit deuxième noeud de tension et ledit noeud interne ;
un circuit d'exécution de test TEC, couplé à un circuit de sortie de signal de validation de test, qui exécute une fonction de test dudit dispositif à semiconducteurs en réponse à un signal de validation de test ;
**caractérisé par** :
un commutateur, couplé entre ledit noeud interne et ladite borne de test, qui connecte électriquement ledit noeud interne à ladite borne de test lorsqu'il est validé par ledit signal de validation de test ;
ledit circuit de sortie de signal de validation de test, couplé audit noeud interne, qui délivre en sortie le signal de validation de test en fonction du niveau de tension dudit noeud interne ; et
dans lequel ledit circuit de sortie de signal de validation de test comprend :
une porte inverseuse (18) ayant une borne d'entrée couplée audit noeud interne et une borne de sortie ;
un circuit de verrou (303) couplé entre la borne de sortie de ladite porte inverseuse et ledit circuit d'exécution de test, qui verrouille une sortie de signal venant de ladite porte inverseuse et délivre en sortie le signal de validation de test.

2. Dispositif à semiconducteurs selon la revendication 1, dans lequel ledit commutateur comprend un transistor métal-oxyde-semiconducteur (MOS) (28) ayant une électrode couplée audit noeud interne, une autre électrode couplée à ladite borne de test et une électrode de grille couplée audit circuit de sortie de signal de validation de test.

3. Dispositif à semiconducteurs selon la revendication 1 ou 2, dans lequel le deuxième niveau de tension est supérieur au premier niveau de tension, et dans lequel ledit élément de fusible est coupé lorsque le signal de validation de test est appliqué audit commutateur et qu'un troisième niveau de tension qui est supérieur au premier niveau de tension est appliqué à ladite borne de test.

4. Dispositif à semiconducteurs selon la revendication 3, dans lequel le troisième niveau de tension est sensiblement identique au deuxième niveau de tension.

5. Dispositif à semiconducteurs, comprenant :
un premier noeud de tension (30) auquel est délivré un premier niveau de tension ;
un deuxième noeud de tension (40) auquel est délivré un deuxième niveau de tension ;
un noeud interne (401) ;
un élément de fusible (12) couplé entre ledit premier noeud de tension et ledit noeud interne ;
un élément résistif (16), couplé entre ledit deuxième noeud de tension et ledit noeud interne, qui maintient un niveau de tension dudit noeud interne au deuxième niveau de tension ;
un circuit d'exécution de test TEC, couplé à un circuit de sortie de signal de validation de test, qui exécute une fonction de test dudit dispositif à semiconducteurs en réponse à un signal de validation de test ;
**caractérisé par** :
un commutateur, couplé entre ledit noeud interne et ledit deuxième noeud de tension, qui connecte électriquement ledit noeud interne audit deuxième noeud de tension lorsqu'il est validé par un signal de commande de commutateur ;
ledit circuit de sortie de signal de validation de test, couplé audit noeud interne, qui délivre en sortie ledit signal de validation de test en fonction du niveau de tension dudit noeud interne ;
un noeud d'entrée de signal de coupure de fusible pour entrer un signal de coupure de fusible CUT ; et
un circuit de commande de commutateur (32), couplé audit circuit de sortie de signal de validation de test et audit noeud d'entrée de signal de coupure de fusible, qui délivre en sortie le signal de commande de commutateur en réponse au signal de coupure de fusible et au signal de validation de test ; et
dans lequel ledit circuit de sortie de signal de validation de test comprend :
une porte inverseuse (18) ayant une borne d'entrée couplée audit noeud interne et une borne de sortie ;
un circuit de verrou (303) couplé entre la borne de sortie de ladite porte inverseuse et ledit circuit d'exécution de test, qui verrouille un signal délivré en sortie de ladite porte inverseuse et délivre en sortie le signal de validation de test.

6. Dispositif à semiconducteurs selon la revendication 5, dans lequel ledit commutateur comprend un transistor métal-oxyde-semiconducteur (MOS) (28) ayant une électrode couplée audit noeud interne, une autre électrode couplée audit deuxième noeud de tension et une électrode de grille couplée audit circuit de commande de commutateur.

7. Dispositif à semiconducteurs selon l'une des revendications 1 à 6, dans lequel ledit élément résistif comprend une résistance ayant une extrémité couplée audit noeud interne et une autre extrémité couplée audit deuxième noeud de tension.

8. Dispositif à semiconducteurs selon l'une des revendications 5 à 7, dans lequel ledit élément de fusible est coupé lorsque le signal de commande de commutateur est appliqué audit commutateur.
